# EUROPEAN PATENT APPLICATION

(11) **EP 1 975 992 A1**
(43) Date of publication of application: **01.10.2008**
(21) Application number: 06841761.7
(22) Date of filing: 26.12.2006
(51) Int. Cl.: H01L 21/56, H01L 23/29, H01L 27/142, H01L 31/0203, H01L 31/048, H01L 31/18

(54) **SELF-SUPPORTING, PHOTOVOLTAIC PASSIVE REFRIGERATOR MODULE**

(30) Priority: 04.01.2006 ES 200600057
(71) Applicant: Universidad de Sevilla, E-41012 Sevilla (ES)
(72) Inventor: LILLO BRAVO, Isidoro, 41092 Sevilla (ES); RUIZ HERNÁNDEZ, Valeriano, 41092 Sevilla (ES)
(74) Representative: Temino Ceniceros, Ignacio
(86) International application number: PCT/ES2006/000709
(87) International publication number: WO 2007/077277

(57) **Abstract**

The invention relates to a photovoltaic module consisting of an encapsulant which is disposed on the rear part of the cells, which is a self-supporting passive refrigerator. The material used as a rear encapsulant for the photovoltaic module comprises aluminium which is subjected to an electrolytic oxidation process, such that the aluminium is not electrically conductive and maintains sufficient thermal transmittance. The invention is used to improve the efficiency of devices that are used to produce electrical power with the aid of photovoltaic cells and to extend the use of commercial polycrystalline and monocrystalline silicon cells to solar radiation concentration devices and to architectural integration.

## Description

### OBJECT OF THE INVENTION

This invention relates to a photovoltaic module consiting of an encapsulant that is located on the rear part of the cells that is a self-supporting passive refrigerator. The material that is used as a rear encapsulant for the photovoltaic module is made of aluminium that is subjected to an electrolytic oxidation process, which ensures that the aluminium is not an electricity conductor while at the same time it still maintains sufficient thermal transmittance. The invention is applied to improving the efficiency of devices that are used to produce electricity with the aid of photovoltaic cells and to extend the use of commercial polycrystalline and monocrystalline silicon cells to solar radiation concentration devices and to architectural integration.

### STATE OF THE ART

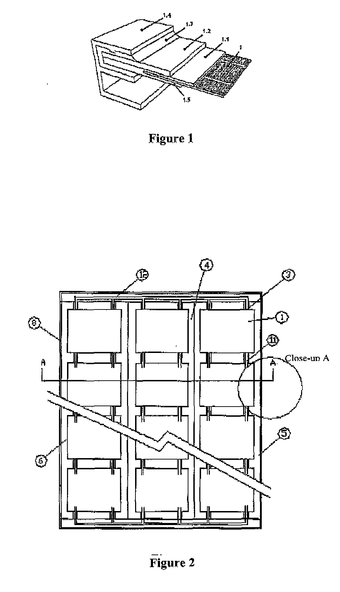

Where the state of the art is concerned, it is a well-known fact that the crystalline silicon photovoltaic module consists of a set of solar photovoltaic cells (1) that are connected to each other encapsulated at the front by a glass (1.2) with a gasket (1.3) and a flexible material (generally EVA) (1.1) and, at the rear, it is also encapsulated with the same flexible material (generally EVA) and an opaque flexible sheet (generally Tedlar) (1.5), with an aluminium frame (1.4). Glass is the element that makes the assembly rigid (Figure 1).

All the major manufacturers in the world (Sharp, Kyocera, BP Solar, Shell Solar, RWE Schott Solar, Mitsubishi Electric, Isofotón, Sanyo, Astropower, Q-Cells, etc.) use this type of encapsulant.

Furthermore, in the case of architectural integration applications, there are certain manufacturers that modify the form of the cell encapsulant. Some of these manufacturers replace the glass front of the cells with other transparent materials such as resins, Tedlar, etc., which are resistant to atmospheric agents, and they make it rigid by incorporating certain resistant elements at the rear. Others use glass, polymers, resins, ceramic elements, etc. at the rear. All of these materials that are in contact with the cells are non-metallic and they are characterised by the fact that not only do they have a low thermal transmittance, but also by the fact that at least one of them has to be rigid. It must be pointed out that under no circumstances do they come into contact with metallic materials, because such materials are electricity conductors and would prevent the cells from associating.

To be specific, the patent with application N° P009901929 and Publication N° 2 153 796, describes a lining for cells with a ceramic support.

The manufacturers of modules also mount the cells between two pieces of glass, such as the module SOLARWATT of the BLACKLINE type, manufactured by the company Solarwatt, and also with rear encapsulants made of plastic or polymers, such as the module manufactured by the company Solardachstien, which encapsulates the cells from the manufacturer Photowatt in a plastic material, which is referred to as polymatrix. The company Sunny Tile, for example, encapsulates with resins, with its star unit module.

As a summary, in Chapter 3 and in Chapter 8 of the book entitled "Photovoltaische Anlagen", written by Ralf Haselhuhn and Fraude Berger, published by DGS, LV Berlin Brandenburg, with ISBN 2-9805738-3-4, there is a detailed review of the technology, which includes all the photovoltaic cell encapsulant systems and their manufacturers all over the world.

In view of what has been explained above, given that the current modules are encapsulated by materials that do not have a high thermal transmittance, this is not conducive to heat dissipation in the cells, and so the cells reach temperatures that are much greater than the temperature in the environment when solar irradiance acts upon them. It has been demonstrated that the efficiency and effectiveness of photovoltaic cells decreases when their temperature increases, so it is advisable for the cells to invariably reach the lowest possible temperature when solar radiation acts upon them.

Apart from what has been pointed out, commercial cells deteriorate if they reach a temperature that is greater than a specific value (generally 85 °C), which is why the manufacturers' guarantees only apply in circumstances where the cells cannot exceed these temperatures. As a result, the exterior part of these cells needs to be cooled when they are installed in devices where solar radiation is concentrated on the cells. If the exterior part of the cells is not provided with refrigeration the cells exceed the maximum temperatures allowed.

This outer refrigeration is provided by means of water with an exchanger, which means that it is necessary to use a hydraulic circuit with a circulation pump, which makes the installation considerably more expensive and complicated. Another option for limiting the temperature of the cells for these devices is to reduce the concentration of solar radiation when a maximum temperature is exceeded. However, in such cases the installations lose effectiveness and efficiency, in view of the fact that they do not make the most of all the solar radiation that the cells are subjected to.

Furthermore, electrolytic oxidation processes are well known for treating aluminium in order to protect it from the environmental conditions, and the same applies to their use in windows, doors, etc., but they are not required because of their electrical isolation and heat transmittance properties.

### DESCRIPTION OF THE INVENTION

The present invention is a self-supporting, photovoltaic passive refrigerator module, which is characterised by the fact that it has a high thermal transmittance, it is rigid and the total cost involved in producing the module is similar to or cheaper than the cost of those products that are currently available on the market.

The material that is used as rear encapsulant for the photovoltaic cells is aluminium that has been subjected to a chemical process of electrolytic oxidation in which the aluminium is the anode. This process ensures that the aluminium is not a conductor of electricity and that it has a strong thermal transmittance.

The encapsulant is obtained in the form of aluminium strips that have been extruded by means of a previously designed mould with slits conducive to the connections between the cells and the anodized aluminium.

The mechanical and thermal characteristics of the photovoltaic module are a result of a combination of the length of the extruded part and the thickness of the aluminium, which provide the module with its mechanical strength, as well as by the way the mould for extrusion is designed and provided with flaps that dissipate the heat, generally improving the heat transmittance of the module.

Another possibility involves directly using sheets of aluminium into which slits have been made before subjecting them to the same surface treatment as the strips of aluminium obtained by extrusion.

The encapsulant is then subjected to a chemical process of electrolytic oxidation, which is applied to the surface that comes into contact with the cells, thereby ensuring that the aluminium is not a conductor of electricity. The electrical resistance depends on how long the electrolytic oxidation process lasts: the greater the oxidation, the greater the resistance owing to the greater thickness of the oxidised layer. This treatment ensures that there will be no short circuit between the cells that are connected to each other.

The chemical treatment by electrolytic oxidation gives it a silver colour, but in a preferred embodiment and for the purpose of architectural blending, other colours are available that can be obtained by submerging the aluminium in tin salts and other substances that can give it different colours.

The interconnected cells are laid upon the aluminium encapsulant and a flexible resin is preferably laid upon the cells. Furthermore, airtight boxes are provided that serve as a means for connecting up the different encapsulants where the connectors run in and out linking the cells that belong to each encapsulant.

The whole assembly can be subjected to a vacuum heat process to guarantee that the cells are insulated against heat from the exterior and that they are isolated from an electrical perspective, although flexible front linings are currently available that guarantee both insulation and isolation without the vacuum process being required, such as for example, using adhesive.

The front surface of the cells is protected from the exterior with transparent material (flexible resin, Tedlar, very fine glass, etc.), it not being necessary to use glass with the current thicknesses because the rigidity of the assembly is guaranteed with the rear encapsulant that is the object of the invention.

The photovoltaic module that is the object of the invention serves as a construction element because it can be used as a facade, an enclosure, a ledge, a cornice or roofing of any type, guaranteeing not only the creation but also the separation of zones, thanks to its high level of mechanical resistance and its air tightness qualities. Furthermore, if the rear encapsulant is equipped with flaps, as in the case of the mould designed for extrusion, and if it is thought desirable to do so, it is possible to make the most of the heat released by the flaps.

### DESCRIPTION OF THE FIGURES

Figure 1.- Section of a photovoltaic module currently available on the market, showing the different materials used to make it:
   1. Photovoltaic cell.
   1.1 EVA.
   1.2 Glass.
   1.3 Sealing gasket.
   1.4 Frame.
   1.5 Tedlar.
Figure 2.- Example of a front view of the photovoltaic module that shows the following:
   1. Photovoltaic cells.
   2. Transparent resin.
   3. Slits.
   4, 5 and 6. Passive refrigerator encapsulant.
   8. Holes.
   11. Connecting wires.
   12. Upper and lower section.

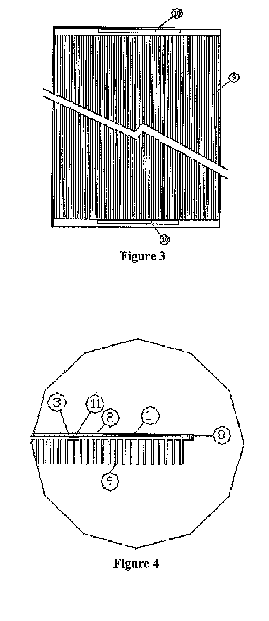

Figure 3.- Example of a view of the photovoltaic module, seen from the back, where the following can be observed:
   9. The flaps.
   10. The airtight boxes.
Figure 4.- Close-up of the section shown in Figure 2, showing the following:
   1. Photovoltaic cells.
   2. Transparent resin.
   3. Slits.
   8. Holes.
   9. The flaps.
   11. Connecting wires.

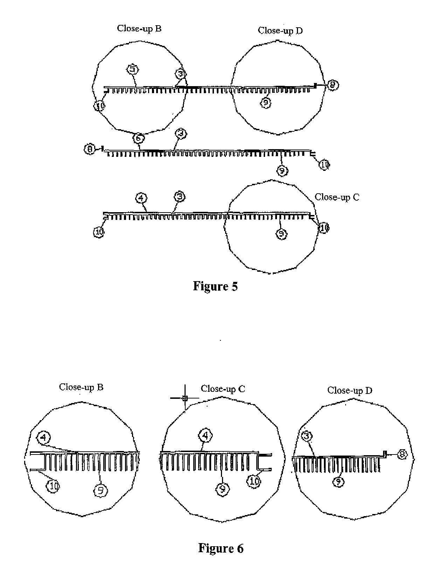

Figure 5.- Plan view from the front, of the strips (4), (5) and (6) that make up the rear encapsulant.
Figure 6.- Section of the strips (4), (5) and (6) that make up the rear encapsulant, showing the following:
   3. Slits.
   8. Holes.
   9. Flaps
   10. Section of connectors between strips.
Figure 7.- Shows three close-ups of the ends of the strips that can be seen in Figure 6.

### REALISATION OF AN EMBODIMENT OF THE INVENTION.

A description is given below of the invention based upon the figures referred to above.

The self-supporting, photovoltaic passive refrigerator module that is the object of the invention, is formed by a rear encapsulant made of aluminium that is subjected to a process of electrolytic oxidation, with a view to preventing it from being a conductor of electricity and to guarantee the thermal transmittance quality of the encapsulant.

The encapsulant is obtained in the following way:
A mould is designed to be used with a view to extruding the aluminium to the desired shape [slits (3), flaps (9), joint sections between strips (10), etc.]: one mould is required for the central strips (4), a second mould is needed for the right-hand strip (5) and a third mould is required for the left-hand strip (6).

These aluminium strips are cut to the required length, before being subjected to a process of electrolytic oxidation, especially on the surface where the slits have been made.

Another possibility involves directly using aluminium sheets in which slits are made, and are subjected to exactly the same surface treatment.

The treated aluminium strips are connected to each other to form the rear encapsulant for the cells by means of connection sections (10) on the strip itself. Every module will consist of one or several central strips (4), one right-hand strip (5) and one left-hand strip (6). One single module with one single strip could also be made.

After that, the photovoltaic cells, already connected up to each other, are then placed on each one of the strips of the rear encapsulant with the connecting wire between cells (11) laid over the slits.

A means for protection is placed at the top, which in a preferred embodiment will be a flexible transparent resin (2) that is subjected to a heat process so that the resin can be made to stick to the photovoltaic cells (1) and to the rear encapsulant (4, 5 and 6). Another way of doing this is to stick this transparent resin (2) to the cells and to the rear encapsulant. Either of these two options serves to protect the cells from the exterior.

Finally, the positive and negative terminals are connected to some airtight boxes (10) that are placed on the upper and lower sections of the module (12).

## Claims

1. A self-supporting, photovoltaic passive refrigerator module **characterised by** the fact that the rear encapsulant is composed of aluminium sheets in which slits have been made, which are then subjected to a process of electrolytic oxidation on the surface that comes into contact with the photovoltaic cells in order to obtain a material that has a very low level of electrical conductivity and a high thermal transmittance.

2. A self-supporting, photovoltaic passive refrigerator module as in Claim 1, **characterised by** the fact that the aluminium sheets can be obtained by extruding the aluminium in a mould designed beforehand.

3. A self-supporting, photovoltaic passive refrigerator module as in claims 1 and 2, **characterised by** the fact that the mould can be equipped with flaps, to obtain a rear encapsulant with heat-dissipating flaps, thereby improving the thermal transmittance of the photovoltaic module.

4. A self-supporting, photovoltaic passive refrigerator module as in the preceding claims, **characterised by** the fact that the size of the encapsulant is given by the length of the extrusion and the thickness of the aluminium, which provide the module with its mechanical strength.

5. A self-supporting, photovoltaic passive refrigerator module as in the preceding claims, **characterised by** the fact that the front protection for the photovoltaic cells is provided by a transparent lining that is resistant to the atmospheric elements.

6. A self-supporting, photovoltaic passive refrigerator module as in claim 5, **characterised by** the fact that the lining is a transparent resin.

7. A self-supporting, photovoltaic passive refrigerator module as in the preceding claims, **characterised by** the fact that the connection between the encapsulants is provided by an airtight box through which the connectors linked to the cells belonging to each encapsulant run in and out.

8. Use of the self-supporting, photovoltaic passive refrigerator module as a construction element for wall, an enclosure, a ledge, a cornice or roofing.
